(19) Europäisches Patentamt
European Patent Office
Office européen des brevets

(11) **EP 4 617 959 A1**

(12) **EUROPEAN PATENT APPLICATION**

(43) Date of publication:
**17.09.2025 Bulletin 2025/38**

(21) Application number: **25163161.0**

(22) Date of filing: **12.03.2025**

(51) International Patent Classification (IPC):
**G06N 10/40** (2022.01) **H10N 69/00** (2023.01)

(52) Cooperative Patent Classification (CPC):
**G06N 10/40; H10N 69/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.03.2024 FI 20245294**

(71) Applicant: **IQM Finland Oy
02150 Espoo (FI)**

(72) Inventor: **OCKELOEN-KORPPI, Caspar
02150 Espoo (FI)**

(74) Representative: **Berggren Oy
P.O. Box 16
Eteläinen Rautatiekatu 10A
00101 Helsinki (FI)**

(54) **FLUX LINE GROUNDING FOR QUANTUM PROCESSOR**

(57) There is provided mitigating Purcell loss at qubit frequency. A flux line (106) for manipulating a plurality of qubits, comprises: a first segment (1902) for connecting to an input terminal for receiving a control signal and for coupling the control signal to a plurality of qubits arranged in proximity of the flux line; and one or more further segments (1904a, 1904b) consecutive to the first segment (1902), wherein each of the further segments is configured to extend between a first qubit of the plurality of qubits and, a second qubit of the plurality of qubits or a termination to the ground, wherein the second qubit is a subsequent qubit after the first qubit along the flux line (106); and the flux line comprises a longitudinal dimension of the flux line between the first qubit and, the second qubit or the termination to the ground, of a given further segment of said one or more further segments (1904a, 1904b) is a multiple of a half a wavelength of a wave of the control signal carried by the flux line at a qubit frequency of the first qubit of the given further segment.

Fig. 19

**Description**

FIELD OF THE INVENTION

The invention is generally related to the field of quantum computing. In particular, the invention is related to flux lines carrying control signals for qubit manipulation in quantum processors.

BACKGROUND OF THE INVENTION

A quantum computing device, also referred to as a quantum computer, uses quantum mechanical phenomena, such as superposition and entanglement, to perform required quantum computing operations. Unlike a conventional computer that manipulates information in the form of bits (e.g., "1" or "0"), the quantum computer manipulates information using qubits. A qubit may refer not only to a basic unit of quantum information but also to a quantum device that is used to store one or more qubits of information (e.g., the superposition of "0" and "1").

Quantum computing devices are implemented by superconducting circuits that typically use frequency multiplexed qubit readout using one or more resonators per qubit, where multiple qubits are read out by a single shared probe line. The qubits may be coupled to the single shared probe line by a readout resonator and one or more Purcell-filter resonators. The resonators should be tuned relative to each to each other for accurate and reliable readout of the qubit states.

Qubit manipulation is used in quantum computers for performing quantum operations. Transmission lines, or flux lines, are used to carry control signals, whose magnetic field is coupled to the qubits for manipulating the qubits. Grounding the flux lines on the same plane near the qubits can cause current propagation on qubit plane and DC (Direct Current) crosstalk to other flux lines and qubits. For example, DC (Direct Current) may cause crosstalk to qubit/couplers tuning and AC (Alternating Current) may cause cross talk for two qubit gates operations. In large quantum processing units, the number of qubits can be 20 or more, whereby flux lines and qubits can be close to each other which can lead to increased crosstalk.

In a transmission line, signals propagate through a "transmission line mode", which is a 2D electromagnetic field shape that ideally "fits" the cross-section of the transmission line. It is a special field distribution that, if you excite it at one end, it will neatly propagate along the line with the same field distribution. The transmission line mode can be described by a pair of parameters, for example impedance and propagation speed. In lossy media there is a third parameter, loss rate, which is very low for superconducting flux lines. A transmission line with a single conductor supports a single transmission line mode. Hence, it has a single impedance and propagation speed. A twin-co-planar waveguide supports two transmission line modes. These are two different field distributions, that each propagate neatly without changing shape, and also without going from one mode to the other. It turns out, that (for a symmetric twin CPW) these modes each have a distinct symmetry: the "differential" mode, where the voltage on one conductor is always the opposite of the voltage of the other conductor, and the "common", where the voltage on both conductors is always the same. Each mode has its own characteristic impedance and propagation speed. What exact values these are depends on the geometry, e.g. line widths and gaps, of the transmission line.

Flux lines should be matched to system impedance, e.g. system impedance of 50 Ohm, to allow for flux pulses at DC and from flux pulses at DC up to flux pulses at an intermediate frequency, thus below a qubit frequency, with little distortion. However, 50 Ohm flux lines are hard to implement on platforms that comprise multilayer wiring on silicon. Parasitic capacitive coupling causes a Purcell decay channel which will be limiting as we move to higher coherence qubits.

SUMMARY

This summary is provided to introduce a selection of concepts in a simplified form that are further described below in the detailed description. This summary is not intended to identify key features of the invention, nor is it intended to be used to limit the scope of the invention.

The objective of the invention is to provide a technical solution to mitigate Purcell loss at qubit frequency.

The objective above is achieved by the features of the independent claims in the appended claims. Further embodiments and examples are apparent from the dependent claims, the detailed description and the accompanying drawings.

According to a first aspect, there is provided flux line for manipulating a plurality of qubits, comprising:

- a first segment for connecting to an input terminal for receiving a control signal and for coupling the control signal to a plurality of qubits arranged in proximity of the flux line; and
- one or more further segments consecutive to the first segment, wherein each of the further segments is configured to extend between a first qubit of the plurality of qubits and, a second qubit of the plurality of qubits or a termination to the ground, wherein the second qubit is a subsequent qubit after the first qubit along the flux line; and the flux line comprises at least one of the following:

- a longitudinal dimension of the flux line between the first qubit and, the second qubit or the termination to the ground, of a given further segment of said one or more further segments is a multiple of a half a wavelength of a wave of the control signal carried by the flux line at a qubit frequency of the first qubit of the given further segment; or
- the first segment and said one or more further segments of the flux line each comprise a low pass filter, or a band stop filter between the first qubit and, the second qubit or a termination to the ground.

According to a second aspect there is provided a superconducting chip, or chip package, comprising a plurality of qubits on one or more substrates; and one or more flux lines according to an aspect for manipulating said plurality of qubits.

According to a third aspect there is provided a quantum computing apparatus comprising at least one superconducting chip, or chip package, according to an aspect and a control unit connected to the at least one superconducting chip, or chip package, and the control unit is configured to feed one or more control signals to at least one flux line for manipulating said plurality of qubits.

At least some aspects provide mitigating Purcell loss at qubit frequency.

BRIEF DESCRIPTION OF THE DRAWINGS

The invention is explained below with reference to the accompanying drawings in which:

Fig. 1a illustrates an example of a superconducting circuit in accordance with at least some embodiments;
Fig. 1b illustrates an example of a superconducting chip in accordance with at least some embodiments;
Figs. 2 and 3 illustrate examples of grounding of a flux line for a control signal in superconducting chips comprising a single substrate, in accordance with at least some embodiments;
Figs. 4 to 11 illustrate examples of grounding of a flux line for a control signal in a superconducting chip package, in accordance with at least some embodiments;
FIG. 12 shows a block diagram of a quantum computing apparatus in accordance with at least some embodiments;
Figs. 13 to 16 illustrate examples of flux lines in accordance with at least some embodiments;
Figs. 17 and 18 illustrate examples of characteristics of flux lines in accordance with at least some embodiments; and
Figs. 19 and 20 illustrate examples of flux lines for multiplexed manipulation of qubits in accordance with at least some embodiments; and
Fig. 21 illustrates examples of characteristics of flux lines for multiplexed manipulation of qubits in accordance with at least some embodiments.

DETAILED DESCRIPTION

Various embodiments of the invention are further described in more detail with reference to the accompanying drawings. However, the invention may be embodied in many other forms and should not be construed as limited to any certain structure or function discussed in the following description. In contrast, these embodiments are provided to make the description of the invention detailed and complete. According to the detailed description, it will be apparent to the ones skilled in the art that the scope of the invention encompasses any embodiment thereof, which is disclosed herein, irrespective of whether this embodiment is implemented independently or in concert with any other embodiment of the invention. For example, the chips and apparatus disclosed herein may be implemented in practice by using any numbers of the embodiments provided herein. Furthermore, it should be understood that any embodiment of the invention may be implemented using one or more of the elements presented in the appended claims.

In the present application, similar or corresponding elements and components across different figures and embodiments are referred to using the same reference numbers. The use of consistent reference numbers is intended to denote their similarity or correspondence unless otherwise stated.

The word "exemplary" is used herein in the meaning of "used as an illustration". Unless otherwise stated, any embodiment described herein as "exemplary" should not be construed as preferable or having an advantage over other embodiments.

Any positioning terminology, such as "left", "right", "upper", "lower", etc., may be used herein for convenience to describe one element's or feature's relationship to one or more other elements or features in accordance with the figures. It should be apparent that the positioning terminology is intended to encompass different orientations of the chip disclosed herein, in addition to the orientation (s) depicted in the figures. As an example, if one imaginatively rotates the chip in the figures 90 degrees clockwise, elements or features described as "left" and "right" relative to other elements or features would then be oriented, respectively, "above" and "below" the other elements or features. Therefore, the positioning terminology used herein should not be construed as any limitation of the invention.

Although the numeric terminology, such as "first", "second", etc., may be used herein to describe various embodiments and the features thereof, it should be understood that the embodiments and the features thereof should not be limited by this numeric terminology. This numeric terminology is used herein only to distinguish one embodiment or feature from another embodiment or feature. Thus, a first embodiment discussed below could be called a second embodiment and vice versa, without departing from the teachings of the invention.

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

As used herein, "at least one of the following" and "at least one of" and similar wording, where the list of two or more elements are joined by "and" or "or", mean at least any one of the elements, or at least any two or more of the elements, or at least all the elements.

As used in the embodiments disclosed herein, a qubit may refer to a superconducting quantum device, or a superconducting element, configured to store one or more quantum bits of information (or qubits for short). In this sense, the qubit serves as a quantum information storage and processing device. The source of nonlinearity in the qubit may be represented by one or more Josephson junctions. The term "Josephson junction" is used herein in its ordinary meaning and may refer to a quantum mechanical device made of two superconducting electrodes which are separated by a barrier (e.g., a thin insulating tunnel barrier, normal metal, semiconductor, ferromagnet, etc.).

According to the embodiments disclosed herein, a quantum computing apparatus, also referred to as a quantum computer, may refer to an apparatus that comprises at least one superconducting chip and a control unit connected to the at least one superconducting chip, and the control unit is configured to feed one or more control signals at least one flux line for manipulating at least one qubit. Manipulation the at least one qubit, or more generally qubit manipulation, facilitates the quantum computing apparatus to perform quantum computing operations, such as reading the state of a qubit, initializing the state of the qubit, and entangling the state of the qubit with the states of other qubits in the quantum computing apparatus, etc. Existing implementation examples of such quantum computing apparatuses may include superconducting quantum computers, trapped ion quantum computers, quantum computers based on spins in semiconductors, quantum computers based on cavity quantum electrodynamics, optical photon quantum computers, quantum computers based on defect centers in diamond, etc. The readout may be a frequency-multiplexed readout of the qubits connected to a common feedline by resonator structures.

As used in the embodiments disclosed herein, a flux line is used interchangeably to refer to a transmission line that is arranged to couple a control signal to a Superconducting Quantum Interference Device (SQUID) operatively connected to at least one qubit in a superconducting chip or a superconducting chip package. The control signal may be a microwave signal, for example a DC signal or AC signal, carried by the flux line.

In an example, the control signal is coupled inductively to the SQUID. Accordingly, a magnetic field caused by the control signal induces a current to the SQUID, whereby the control signal is coupled to the SQUID and a qubit island where the qubit is located. In this way the qubit may be manipulated by the control signal. The principle of operation of a SQUID is based on the Josephson effect, where a superconducting current can tunnel through a thin insulating barrier between two superconductors. This effect is extremely sensitive to the magnetic field in and around the loop formed by the superconductors, which alters the phase difference of the superconducting wavefunction across the junction and thereby changes the current. Therefore, a voltage coupled to the SQUID is dependent on the magnetic field caused by the control signal. It is noted that, the voltage coupled by way of the inductive coupling to the SQUID, should be differentiated from other forms of coupling, e.g. a capacitive coupling, thus a coupling by way of an electric field, and from a coupling by way of both a magnetic field and an electric field.

Flux line multiplexing refers to a technique used in quantum computing to manipulate multiple qubits by a control signal carried by a single flux line. Accordingly, the flux line multiplexing provides multiplexed manipulation of qubits through a single flux line.

The exemplary embodiments disclosed herein provide a technical solution for flux lines of superconducting chips, or chip packages, where Purcell loss at qubit frequency can be managed, whereby the above-sounded drawbacks of the prior art may be mitigated or even eliminated.

Superconducting circuit refers to a collection of interconnected superconducting elements that work together to perform a specific function. These circuits are typically fabricated on a substrate using superconducting materials, such as niobium or aluminum, which exhibit zero electrical resistance at very low temperatures. Superconducting circuits can take various forms, such as flux lines, transmission lines, transmission line resonators, co-planar waveguides, Josephson junctions, SQUIDs (Superconducting Quantum Interference Devices), or qubits used in quantum computing. They are designed to exploit the unique properties of superconductors, such as the ability to carry persistent currents and exhibit quantum effects. Superconducting circuits are used in applications like quantum computing, high-speed digital electronics, and ultra-sensitive detectors.

Superconducting chip refers to the physical implementation of a superconducting circuit on a chip-scale device. It involves fabricating a superconducting circuitry on a small semiconductor substrate, often made of silicon or sapphire, using advanced microfabrication techniques. The superconducting chip typically contains multiple superconducting elements, such as flux lines, transmission lines, transmission line resonators, co-planar waveguides, Josephson junctions or SQUIDs, interconnected to form a functional circuit. The chip may also include control and readout electronics, cryogenic cooling infrastructure, and other components necessary for its operation. In the context of quantum computing multiple superconducting qubits may be integrated on a single chip. These qubits can be manipulated and measured collectively to perform quantum computations. Superconducting chips are also used in other applications like analog-to-digital converters, microwave amplifiers, and signal processing systems.

Flip-chip bonding is a packaging technique for electronic devices, particularly in microelectronics and semiconductor industries. It involves the attachment of an integrated circuit (IC) chip directly onto a substrate or another chip, typically using solder bumps or other conductive materials. The term "flip-chip" refers to the orientation of the IC chip during the bonding process. Instead of mounting the chip with its active surface facing up, as done in traditional packaging methods, the chip is flipped over so that its active surface, which contains the circuitry and contact pads, faces downward. This allows for direct electrical connections between the chip and the substrate or other chips. The bonding process involves aligning the solder bumps or conductive contacts on the chip with corresponding pads or traces on the substrate. The chip is then pressed onto the substrate, and the solder bumps are heated, melting the solder and creating electrical and mechanical connections between the chip and the substrate. Once the solder cools and solidifies, it forms a reliable and high-density interconnection between the chip and the substrate.

Qubit plane is a conductive plane of a superconducting chip comprising one more qubit. Flux lines for controlling associated qubits are located on a neighboring conductive plane on the superconducting chip. Each of the flux lines is at one end connected to a source of a control signal and at another end positioned close to a qubit associated with the flux line. In this way a magnetic flux of the control signal may be coupled with a SQUID operatively connected to the qubit associated with the flux line.

Qubit island refers to portion, e.g. a region, of a superconducting chip, where one or more qubits are located.

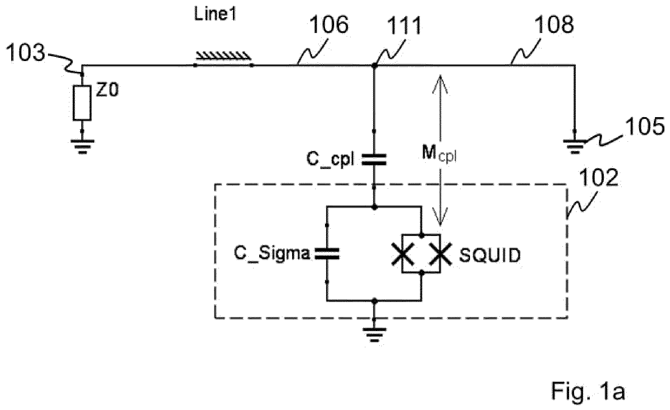

Fig. 1a illustrate an example of a superconducting circuit in accordance with at least some embodiments. The superconducting circuit comprises at least one qubit 102 and a flux line 106 line arranged to manipulate the at least one qubit. The manipulation of the at least one qubit is provided by coupling a control signal to the at least one qubit. The control signal may be coupled to the at least one qubit by an inductive coupling of the control signal to a SQUID that is operatively coupled to the at least one qubit. The flux line extends longitudinally between opposite ends of the flux line. At one end of the flux line, the flux line is connected to at least one input terminal 103 for receiving a control signal and at another end of the flux line the flux line comprises an antinode for current in proximity of the at the at least one qubit. Thus, the another end, or the antinode, the flux line is very close to the at least one qubit for coupling the control signal to the at least one qubit. At the end of the flux line which is close to the at least one qubit, the flux line may be arranged to be routed to at least one termination to the ground 105. In this way at one end of the flux line, the flux line may be arranged at a position 111 that provides coupling the control signal to the at least one qubit and routing the flux line to the ground. In an example, at the end of the flux line which is close to the at least one qubit, the flux line may be connected to a conductor arrangement 108 connected to at least one termination to the ground. The at least one termination to the ground may be on an opposite side of the substrate than the at least one qubit, or on another substrate than the at least one qubit, whereby the conductor arrangement is configured to route the flux line off the qubit plane, which facilitates mitigating crosstalk from the grounded flux line to other flux lines and their associated qubits. In an example, of the coupling of the control signal to the at least one qubit 102, the control signal may cause a magnetic flux, $M_{cpl}$, to the at least one qubit whereby the at least qubit may be manipulated. Connection of the flux line to the ground at the end that is close to the at least one qubit facilitates controlling parasitic coupling, $C_{cpl}$, that causes Purcell decay. In an example, a superconducting chip or chip package may implement the superconducting circuit, whereby the flux line may be provided on a neighboring plane with the at least one qubit. It should be noted that the flux line is galvanically separated from the at least one qubit and sufficiently close to the at least one qubit at a position, e.g. at a sufficiently close distance, where coupling, $M_{cpl}$, of a magnetic flux of the control signal to the at least one qubit. It should be noted that instead of routing the control signal to the at least one termination to the ground, the flux line may be routed to a return of a differential signal, when the flux line is at least partially a self-coupled transmission line.

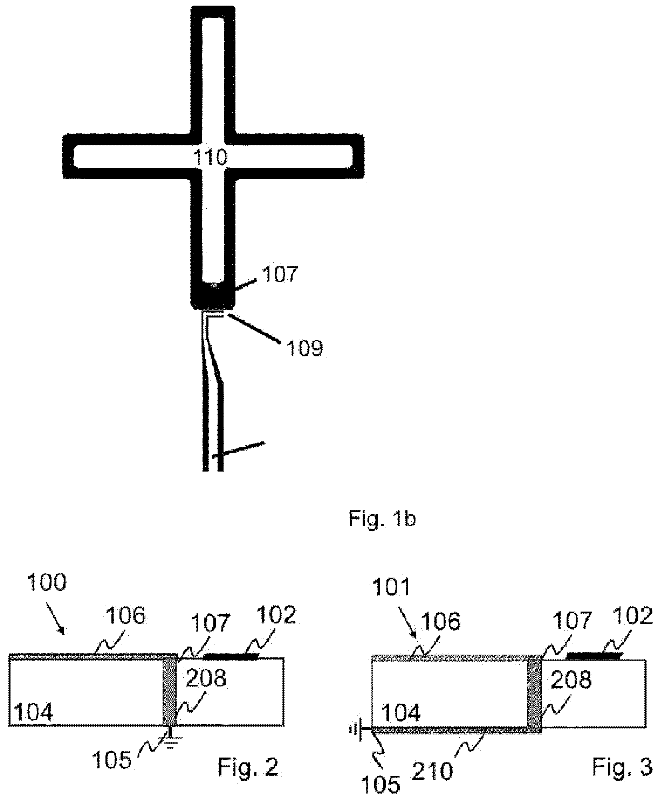

Fig. 1b illustrates an example of a superconducting chip in accordance with at least some embodiments. The superconducting chip of Fig. 1b illustrates a chip-level implementation of superconducting circuit of Fig. 1a. The superconducting chip comprises a qubit island 110 that comprises at least one qubit and a SQUID 107 operatively connected to the at least one qubit. The flux line is positioned very close to qubit island for coupling a control signal to the SQUID for manipulating the qubit. In an example, the control signal may cause a magnetic flux, $M_{cpl}$, to the SQUID operatively connected to the at least one qubit, whereby the at least qubit may be manipulated. The end of the flux line that is close to the at least one qubit is routed to the ground 109 for example by a conductor arrangement 108.

Figs. 2 and 3 illustrate examples of grounding of a flux line for a control signal in superconducting chips comprising a single substrate, in accordance with at least some embodiments. The flux line is routed off the qubit plane and terminated to the ground, whereby crosstalk between the grounded flux line and the qubit plane may be mitigated. The superconducting chips 100, 101 may implement the superconducting circuit of Fig. 1a or at least some elements described with Fig. 1a. The examples illustrated in Figs. 2 and 3 may be used in superconducting chip packages that comprises more than one superconducting chip bonded together. Each of the superconducting chips 100, 101 comprises at least one substrate 104 on which there is provided at least one qubit 102 and a flux line 106 arranged to couple a control signal to the qubit. The superconducting chip comprises at least one termination to the ground 105 on an opposite side of the substrate with respect to the at least one qubit 102. The superconducting chip comprises a conductor arrangement 108 connected to the end of the flux line arranged at the at least one qubit. The conductor arrangement is arranged to route the flux line to the at least one termination to the ground 105. The conductor arrangement may comprise at least one portion 208 that is configured to extend through the first substrate 104 and at least one portion 210 configured to connect the flux line 106 to the at least one termination to the ground on the opposite side of the substrate with respect to the at least one qubit 102. In an example in accordance with at least some embodiments, the conductor arrangement, e.g. a first portion of the conductor arrangement, comprises a through-silicon via (TSV). In an example, the TSV may be configured to extend through the first substrate 104 between opposite surfaces of the substrate. In an example in accordance with at least some embodiments, the conductor arrangement, e.g. a first portion of the conductor arrangement, comprises a through-silicon via (TSV) and a conductor line, e.g. a second portion, configured to connect the TSV to the at least one termination to the ground. In an example, the TSV may be configured to extend through the first substrate 104 between opposite surfaces of the substrate and the conductor line may extend between an end of the TSV at an opposite side of the substrate than the at least one qubit and the at least one termination to the ground. In an example, the at least one termination to the ground 105 may be positioned on an opposite side of the substrate 104 than the at least one qubit at an edge of the first substrate 104.

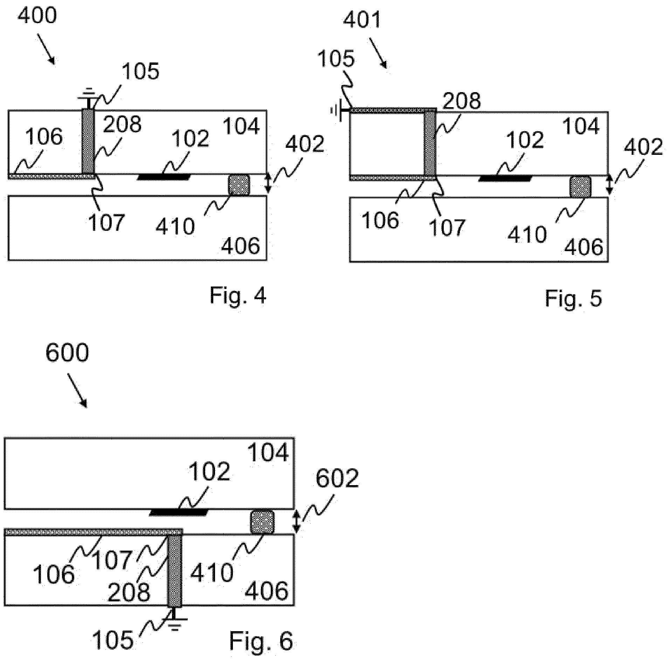

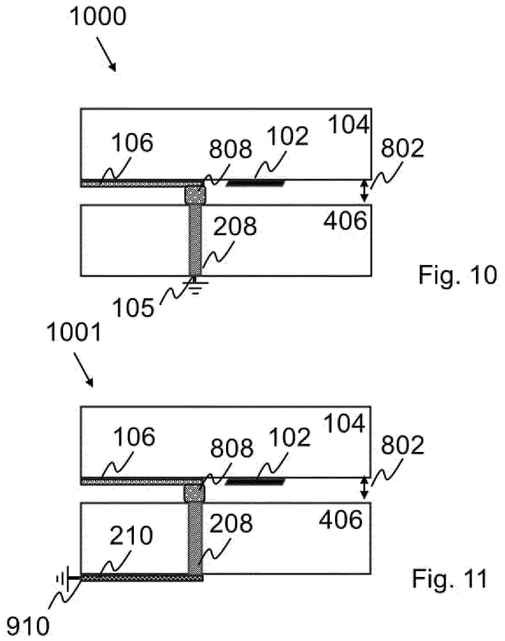

Figs. 4 to 11 illustrate examples of grounding of a flux line for a control signal in a superconducting chip package, in accordance with at least some embodiments. The flux line is routed off a qubit plane and terminated to the ground, whereby crosstalk between the grounded flux line and other flux lines and their associated qubits may be mitigated. The superconducting chip package comprises superconducting chips that are bonded together to form the chip package. Referring to Figs. 4 and 5, each of the superconducting chip packages 400, 401 in Figs. 4 and 5 comprise a first substrate 104, where grounding of a flux line for a control signal is arranged similar to described for the superconducting chips with Figs. 2 and 3 with the differences that the superconducting chip packages comprise bonded substrates and the first substrate 104 is vertically flipped with respect to the superconducting chips illustrated with Figs. 2 and 3. Accordingly, the superconducting chip package 400 comprises a further substrate 406, or a second substrate, that is bonded by one or more bonding elements 410 to the first substrate 104, where the at least one qubit 102 has been provided. Similarly, the superconducting chip package 401 comprises a further substrate 406, or a second substrate, that is bonded by one or more bonding elements 410 to the first substrate 104, where the at least one qubit 102 has been provided. In this way the superconducting chip packages 400, 401 comprise stacked substrates, where at least one surface of each substrate is facing the other substrate. In an example the stacked substrates may be provided by flip-chip bonding of the substrates 104, 406. In an example, the further substrate 406 and the first substrate 104 are separated by a gap 402 formed between the further substrate 406 and the first substrate 104 by the one or more bonding elements.

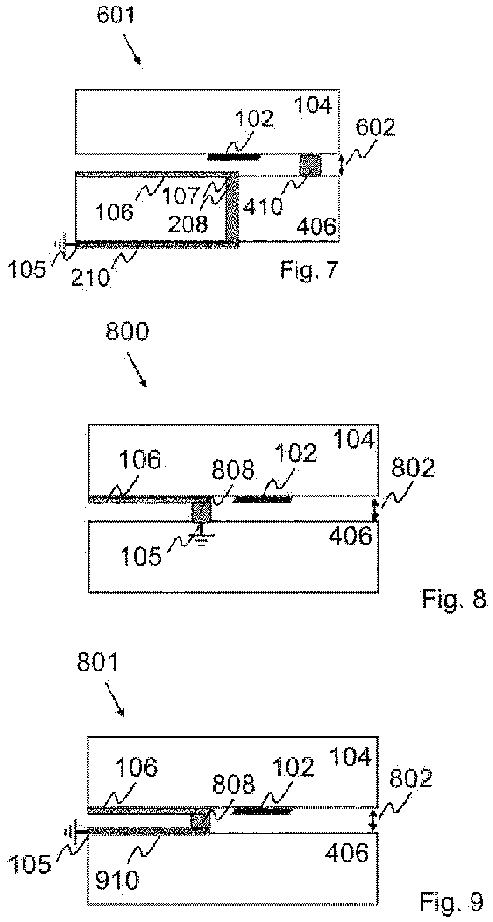

Referring to Figs. 6 and 7, each of the superconducting chip packages 600, 601 in Figs. 6 and 7 comprise superconducting chips that are bonded together to form the chip package. Referring to Figs. 6 and 7, each of the superconducting chip packages 600, 601 in Figs. 6 and 7 comprise a first substrate 104 comprising at least one qubit 102 and a further substrate 406, or a second substrate, that is bonded by one or more bonding elements 410 to the first substrate 104, where the at least one qubit 102 has been provided. The further substrate 406 comprises at least one flux line 106 arranged to couple a control signal to the at least one qubit 102 and at least one termination to the ground 105. The flux line comprises an antinode for current in proximity of the at the at least one qubit. In an example, the antinode for current is the antinode of the current of a control signal carried by the flux line. The antinode may be at an end of the flux line for coupling a control signal to the at least one qubit. In an example, the end of the flux line is arranged on the further substrate under the at least one qubit at the first substrate. Accordingly, the end of the flux line may be positioned on a side of the further substrate 406 facing the first substrate, whereby the flux line may be coupled with the at least one qubit over a gap 602 between the substrates. In an example, the at least one termination to the ground 105 is on an opposite side of the further substrate with respect to the at least one qubit 102, whereby the at least termination to the ground is separated from the first substrate by the further substrate and the gap 602 between the first substrate and the further substrate. In an example, the flux line 106 may be positioned to a side of the further substrate 406 that is facing the first substrate 104. Each of the superconducting chip packages 600, 601 may comprise a conductor arrangement 108 connected to said one end of the flux line, i.e. to position of the antinode, and arranged to route the flux line to the at least one termination to the ground 105. In an example in accordance with at least some embodiments, the conductor arrangement 108 is configured to extend through the further substrate 406 and connect the flux line 106 to the at least one termination to the ground 105 on the opposite side of the further substrate with respect to a side of the further substrate facing the at least one qubit. In an example according to Fig. 6, the conductor arrangement may comprise at least one portion 208 that is configured to extend through the first substrate 104 and to connect the flux line 106 to the at least one termination to the ground 105 on the opposite side of the substrate with respect to the at least one qubit 102. In an example according to Fig. 7, the conductor arrangement may comprise at least one portion 208, e.g. a TSV, that is configured to extend through the first substrate 104 and at least one portion 210, e.g. a conductor line, configured to connect to the first portion on the opposite side of the substrate with respect to the at least one qubit 102 and to the at least one termination to the ground 105 on the opposite side of the substrate for connecting the flux line 106 to the at least one termination to the ground. In an example in accordance with at least some embodiments the conductor arrangement comprises at least one through-silicon via; or a series of at least one through-silicon via and at least one conductor line. In an example, the TSV may be configured to extend through the further substrate 406 between opposite surfaces of the further substrate. In an example in accordance with at least some embodiments, the conductor arrangement comprises a through-silicon via and a conductor line configured to connect the TSV to the at least one termination to the ground. In an example, the TSV may be configured to extend through the further substrate 406 between opposite surfaces of the further substrate and the conductor line may extend between an end of the TSV at an opposite side of the further substrate than a side of the further substrate facing the at least one qubit and the at least one termination to the ground. In an example, the at least one termination to the ground 105 may be positioned on an opposite side of the further substrate 406 than the at least one qubit at an edge of the further substrate 406.

Referring to Figs. 8 to 11, each of the superconducting chip packages 800, 801, 1000, 1001 in Figs. 8 to 11 comprise a first substrate 104 that comprises at least one qubit 102 on a first substrate and at least one flux line 106 comprising an antinode for current in proximity of the at the at least one qubit, and a further substrate 406, or a second substrate, comprising at least one termination to the ground 105. Each of the superconducting chip packages 800, 801, 1000, 1001 comprises a conductor arrangement 108 connected to said antinode for current in proximity of the at the at least one qubit, e.g. one end of the flux line, and arranged to route the flux line to the at least one termination to the ground 105. Similar to described with the superconducting chip packages described with Figs. 4, 5, 6 and 7, the superconducting chip packages 800, 801, 1000, 1001 in Figs. 8 to 11 comprise superconducting chips that are bonded together to form the chip package and the superconducting chip packages comprise bonded substrates that are separated by a gap 802. As a difference to the superconducting chip packages 600, 601, the superconducting chip packages 800, 801, 1000, 1001 in Figs. 8 to 11 comprise the at least one qubit 102 and the flux line 106 on the same substrate 104 similar to the superconducting chips described with Figs. 2, 3, 4 and 5. On the other hand, as a difference to the superconducting chip packages 400, 401, 600, 601 the superconducting chip packages 800, 801, 1000, 1001 in Figs. 8 to 11 comprise conductor arrangements 108 that comprise bonding elements 808 that serve for connecting the flux line 106 the at least one termination to the ground 105 on the further substrate. In an example in accordance with at least some embodiments, the conductor arrangement 108 comprises at least one bonding element 808 that is configured to extend between the first substrate 104 and the second substrate 406, and connect the flux line 106 to the at least one termination to the ground 105 on the second substrate 406.

In an example according to Fig. 8, the conductor arrangement 108 may comprise at least one bonding element 808 that is configured to extend between the first substrate 104 and the second substrate 406, and connect the flux line 106 to the at least one termination to the ground 105 on the second substrate 406.

In an example according to Fig. 9, the conductor arrangement 108 may comprise at least one bonding element 808 that is configured to extend between the first substrate 104 and the second substrate 406, and connect the flux line 106 to at least one conductor line 910 configured to connect to the bonding element 808 and to the at least one termination to the ground 105.

In an example in accordance with at least some embodiments, the conductor arrangement 108 is configured to connect the flux line to at least one termination to the ground 105 through at least one of the following: a bonding element 808; or a series of at least one through-silicon via and at least one conductor line 910; or a series of at least one bonding element 808, at least one through-silicon via and at least one conductor line 910.

In an example, the TSV may be configured to extend through the further substrate 406 between opposite surfaces of the further substrate 406 and the conductor line 910 may extend between an end of the TSV at an opposite side of the further substrate than a side of the further substrate facing the at least one qubit 102. In an example, the at least one termination to the ground 105 may be positioned on the opposite side of the further substrate 406 than the at least one qubit at an edge of the further substrate 406. In an example, the TSV may be at one end connected to the conductor line 910 and at another end connected to the bonding element 808.

Examples of materials for conductive layers, or conductive surface layers, or conductor, comprise at least one of the following: indium; or germanium; or niobium; aluminum; aluminum oxide; or alloys of one or more of the previous; or other materials that display superconducting behaviour in low temperatures. Examples of the other materials comprise organic engineered materials such as carbon nanotubes. Various engineered silicon-based/ceramic materials are also foreseeable, when made superconducting in chip substrate manufacturing process.

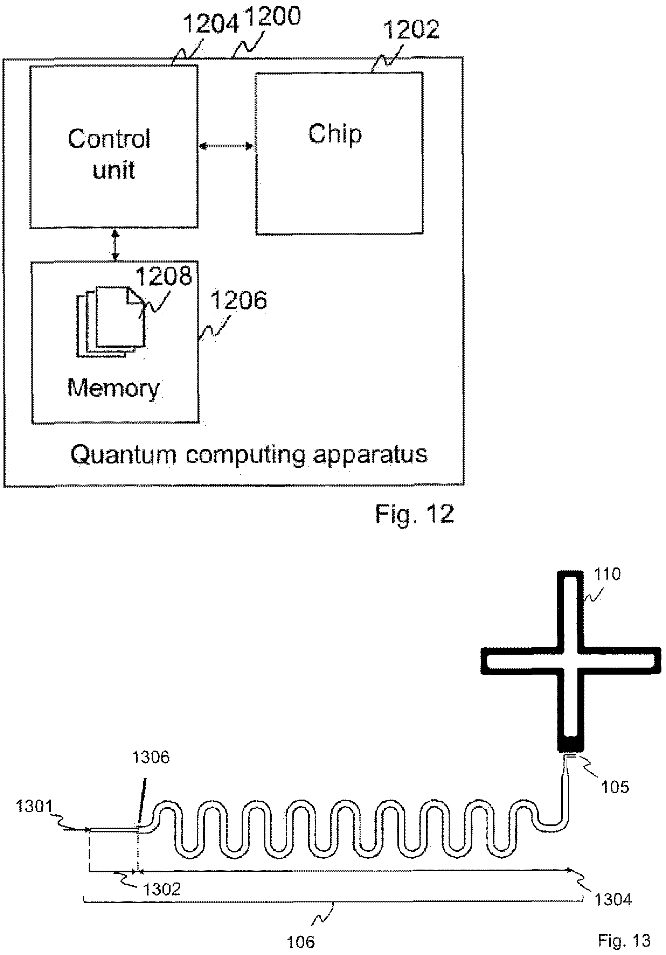

FIG. 12 shows a block diagram of a quantum computing apparatus 1200 in accordance with at least some embodiments. The apparatus 1200 comprises at least one superconducting chip or superconducting chip package 1202 and a control unit 1204 connected to the at least one superconducting chip, or chip package. The chip or superconducting chip package 1202 may comprise one or more superconducting chips or superconducting chip packages in accordance to described with Figs. 2 to 11. The one or more superconducting chips, or chip packages, may comprise one or more flux lines in accordance to described with at least one of Figs. 13 to 16, Fig 19 and Fig. 20. The control unit 1204 is configured to feed one or more control signals to at least one flux line of the one or more superconducting chips, or chip packages, for manipulating at least one qubit or a plurality of qubits.

In an example in accordance with at least some embodiments quantum computing apparatus 1200 comprises at least one superconducting chip or superconducting chip package 1202 comprising at least one arrangement that comprises at least one qubit on a first substrate; at least one flux line comprising an antinode for current in proximity of the at least one qubit, e.g. one end of the flux line; at least one termination to the ground on an opposite side of the first substrate with respect to the at least one qubit or on a second substrate stacked with the first substrate ; and a conductor arrangement connected to said antinode for current in proximity of the at the at least one qubit, e.g. one end of the flux line, and arranged to route the flux line to the at least one termination to the ground; and the quantum computing apparatus 1200 further comprises a control unit 1204 connected to the at least one superconducting chip or superconducting chip package and the control unit is configured to feed one or more control signals to at least one flux line for manipulating the at least one qubit. The apparatus 1200 may further comprise a memory 1206 storing executable instructions 1208 which, when executed by the control unit 1204, may cause the control unit 1204 to perform the quantum computing operations. The control unit 1204 may also store the result(s) of the quantum computing operations to the memory 1206. It should be noted that the number, arrangement and interconnection of the constructive elements constituting the apparatus 1200, which are shown in FIG. 12, are not intended to be any limitation of the present disclosure, but merely used to provide a general idea of how the constructive elements may be implemented within the apparatus 1000.

The control unit 1204 may refer a central processing unit (CPU), general-purpose processor, single-purpose processor, microcontroller, microprocessor, application specific integrated circuit (ASIC), field programmable gate array (FPGA), digital signal processor (DSP), complex programmable logic device, etc. It should be also noted that the control unit 1204 may be implemented as any combination of one or more of the aforesaid. As an example, the control unit 1204 may be a combination of two or more microprocessors.

The memory 1206 may be implemented as a classical nonvolatile or volatile memory used in the modern electronic computing machines. As an example, the nonvolatile memory may include Read-Only Memory (ROM), ferroelectric Random-Access Memory (RAM), Programmable ROM (PROM), Electrically Erasable PROM (EEPROM), solid state drive (SSD), flash memory, magnetic disk storage (such as hard drives and magnetic tapes), optical disc storage (such as CD, DVD and Blu-ray discs), etc. As for the volatile memory, examples thereof include Dynamic RAM, Synchronous DRAM (SDRAM), Double Data Rate SDRAM (DDR SDRAM), Static RAM, etc.

The executable instructions 1208 stored in the memory 1206 may be configured as a computer executable code which causes the control unit 1204 to perform the quantum computing operations by using the chip 1202. The computer executable code for carrying out the quantum computing operations may be written in any combination of one or more programming languages, such as Java, C++, or the like. In some examples, the computer executable code may be in the form of a high-level language or in a pre-compiled form, and be generated by an interpreter (also pre-stored in the memory 1206) on the fly.

Fig. 13 illustrates an example of a flux line in accordance with at least some embodiments. The flux line facilitates mitigating Purcell loss at qubit frequencies. The flux line 106 is illustrated by a chip-level implementation of the superconducting circuit of Fig. 1a. The flux line is provided on a superconducting chip that comprises a qubit island 110. The qubit island comprises at least one qubit and a SQUID 107 operatively connected to the at least one qubit. In accordance with at least some embodiments, the flux line comprises a first segment 1302 for connecting to an input terminal for receiving a control signal, and a second segment 1304 for coupling the control signal to at least one qubit arranged consecutive with respect to the first segment. first segment and the second segment are configured to have an impedance mismatch 1306 at the qubit frequency of the at least one qubit.

In an example in accordance with at least some embodiments the second segment 1304 has a longitudinal dimension that is a multiple of a half a wavelength of a wave the control signal carried by the flux line at a qubit frequency of the at least one qubit.

In an example in accordance with at least some embodiments the second segment 1304 has a lower impedance than the first segment at least at the qubit frequency of the at least one qubit. In this way Purcell loss at qubit frequencies may be mitigated. In an example, the first segment has an impedance that matches with a system impedance at input terminal connected to the first segment for feeding the control signal to the flux line. The second segment is in impedance mismatch with the system impedance. In an example, the impedance of the first segment may be 50 Ohms and the impedance of the second segment may be 10 Ohms at least at the qubit frequency of the at least one qubit.

In an example in accordance with at least some embodiments the second segment 1304 comprises one end that is coupled with the first segment 1302 and another end positioned close to a qubit associated with the flux line 106. The end close to the qubit, i.e. the another end, is routed to the ground. In this way a magnetic flux of the control signal may be coupled with the qubit associated with the flux line while parasitic coupling to the qubit may be mitigated.

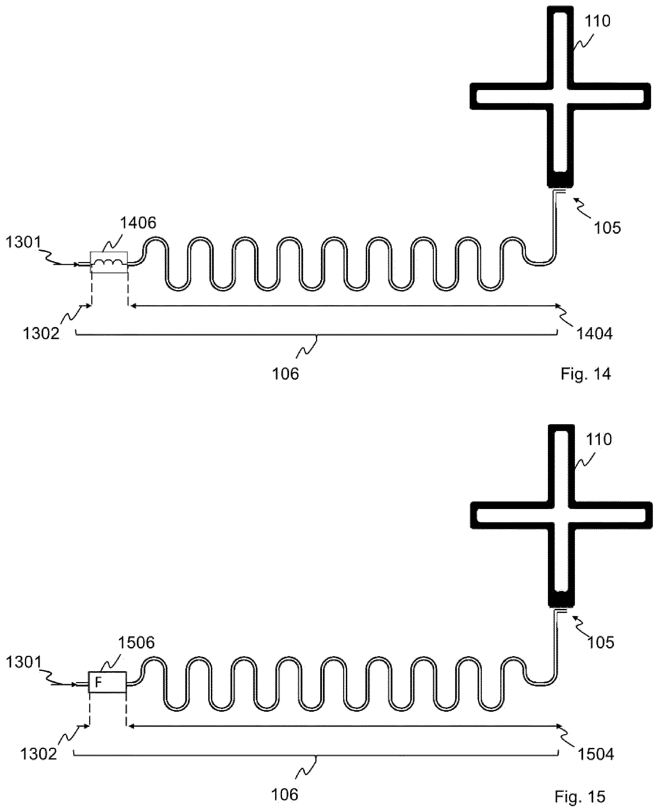

Fig. 14 illustrates an example of a flux line in accordance with at least some embodiments. The flux line facilitates mitigating Purcell loss at qubit frequencies. The flux line is described with reference to the items described with Fig. 13. As a difference to the flux line described with Fig. 13, segments of the flux line in Fig. 14 are connected by an inductor 1406. In this way a first segment 1302 and a second segment 1404 of the flux line are configured to have an impedance mismatch at a qubit frequency of at least one qubit that is manipulated by the control signal carried by the flux line 106. In an example, the impedance of the segment 1404 of the flux line close to the qubit may be lower than the impedance of the segment 1302 for connecting to an input terminal, or the impedances of the segments may be the same, for example 50 Ohms at least at the qubit frequency of the at least one qubit. Accordingly, in Fig. 14 the flux line 106 comprises a first segment 1302 for connecting to an input terminal for receiving a control signal and a second segment 1404 for coupling the control signal to a Superconducting Quantum Interference Device (SQUID) operatively connected to the at least one qubit, wherein the second segment is arranged consecutive with respect to the first segment. The flux line further comprises an inductor 1406 configured to connect the first segment 1302 with the second segment 1304. In this way the inductor is connected in series with the first segment and the second segment which causes the first segment and the second segment to have an impedance mismatch at the qubit frequency of the at least one qubit. In an example, the inductor 1406 may be for example bond wire, or a lumped element inductor, or a waveguide segment with larger induction per unit length than the second segment 1404. In this way the impedance mismatch may be provided.

In an example in accordance with at least some embodiments, the second segment 1404 has a longitudinal dimension that is a multiple of a half a wavelength of a wave of the control signal carried by the flux line at a qubit frequency of the at least one qubit.

Fig. 15 illustrates an example of a flux line in accordance with at least some embodiments. The flux line facilitates mitigating Purcell loss at qubit frequencies. The flux line is described with reference to the items described with Fig. 13. As a difference to the flux line described with Fig. 13, the flux line comprises a filter, for example a low pass filter, or a band stop filter, (F) 1506 configured to connect a first segment 1302 of the flux line with the second segment 1504 of the flux line. In this way the first segment 1302 and the second segment 1504 of the flux line are configured to have an impedance mismatch at a qubit frequency of at least one qubit that is manipulated by the control signal carried by the flux line 106. For example, the impedance of the second segment 1504 of the flux line close to the qubit may be lower than the impedance of the segment 1302 for connecting to an input terminal, or the impedances of the segments may be the same, for example 50 Ohms at least at the qubit frequency of the at least one qubit. In an example, an order of the low pass filter, or band stop filter, 1506 may be designed for increasing Purcell protection and for tailoring frequency response of the filter at low frequencies, for example flatness of the frequency response. In an example in accordance with at least some embodiments, the second segment 1504 has a longitudinal dimension that is a multiple of a half a wavelength of a wave of the control signal carried by the flux line at a qubit frequency of the at least one qubit.

In an example, the filter 1506 may be a low pass filter that has a passband at frequencies of the control signal below the qubit frequency of the at least one qubit and the qubit frequency is at a stop band of the low pass filter. In an example, mitigating the Purcell loss may be supported by designing impedances of the passband and stop band of the low pass filter. The impedance of the low pass filter may be matched at the passband with the impedance of the first segment 1302 and at the stop band the impedance of the low pass filter may be higher than the impedance of the first segment 1302. The second segment 1504 may have the same impedance with the impedance of the first segment. In an example the first segment and the second segment may both have an impedance of 50 Ohms at least at the qubit frequency of the at least one qubit.

In an example, the band stop filter has stop band at the qubit frequency.

In an example, the longitudinal dimension, or length, of the second segment 1304, 1404, 1504 in Figs. 13, 14 and 15 may be defined with respect to a propagation speed of the wave in the flux line. Accordingly, for the flux line and the segment have a phase propagation speed v, whereby a wavelength $\lambda$ in the flux line or the segment of the flux line becomes

$$\lambda = v \, / \, f, \ (1)$$

where $f$ is the qubit frequency.

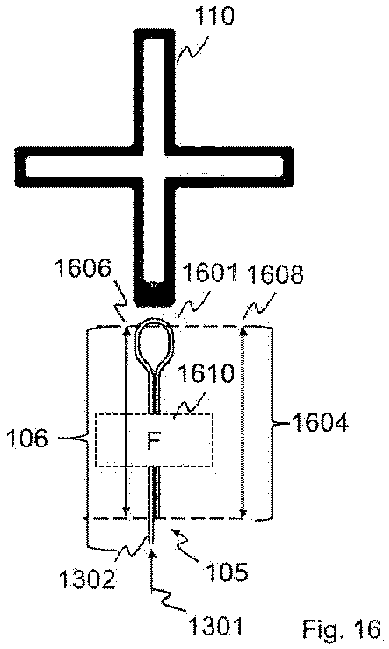

Fig. 16 illustrates an example of a flux line in accordance with at least some embodiments. The flux line facilitates mitigating Purcell loss at qubit frequencies. The flux line is described with reference to the items described with Fig. 13, where applicable. The flux line comprises a first segment 1302 for connecting to an input terminal for receiving a control signal 1301 and a second segment 1604 for coupling the control signal to a Superconducting Quantum Interference Device (SQUID) operatively connected to the at least one qubit, wherein the second segment is arranged consecutive with respect to the first segment. As a difference to the flux line described with Fig. 13, the second segment 1604 is a self-coupled transmission line that has at least two transmission line modes that comprise a differential mode that has an impedance matched with an impedance of the first segment and a common mode that has a lower impedance than the impedance of the differential mode. In this way the flux line is configured to have an impedance mismatch at a qubit frequency of at least one qubit that is manipulated by the control signal carried by the flux line 106. For example, the second segment 1604 may be formed by two consecutive sections of a transmission line, i.e. the second segment 1604. The consecutive sections of the second segment 1604 may comprise a first section 1606 that is routed from the first segment 1302 towards the at least one qubit and to a position 1601 that is close to the at least one qubit for coupling the control signal from the second segment to the at least one qubit. From this position, a second section 1608 of the second segment 1604 starts and the second section of the second segment is routed parallel with the first segment away from the qubit. At an end of the second section 1608 the second segment 1604 may be routed to the ground 105. On the other hand, at an end of the second section the second segment may be: routed to the ground 105 or to a return of a differential signal. In an example, the first section and the second section of the second segment may have at least one common mode and at least one differential mode and an impedance of the second segment at the at least one common mode is lower than an impedance of the second segment at the at least one differential mode. It should be noted that the Purcell decay takes place through the at least one common mode, the second segment may have a low impedance at the at least one common mode for mitigating Purcell decay. It should be noted the impedance of the at least one differential mode may be matched with an impedance of the input terminal for receiving the control signal, or a system impedance. In an example of the flux line of Fig. 16, a voltage on the qubit is coupled to a common mode of the second segment, whereby a (roughly) equal voltage on both left and right conductor of the transmission line, i.e. the first section of the second segment and the second section of the second segment, is created. On the other hand, the control signal may be coupled to a differential mode of the second segment. The differential mode has a matched impedance to an impedance of a source of the control current, e.g. the impedance of the first segment, and the common mode impedance is lower than the impedance of the differential mode, which facilitates reduced Purcell loss.

In an example in accordance with at least some embodiments, the flux line 106 comprises a filter 1610 for common-mode rejection operatively connected to the self-coupled transmission line. The filter provides strengthening the effect of mitigating Purcell loss at the qubit frequency. In an example, the filter is connected to the two consecutive sections of the second segment 1604.

In an example in accordance with at least some embodiments, the second segment 1604 is a twin-co-planar waveguide. In an example, the twin co-planar waveguide comprises parallel conductive paths (or strips) that are on the same plane with ground planes nearby. These two conductive paths are closely spaced and can couple to each other, which is a form of self-coupling. The twin-co-planar waveguide supports two transmission line modes. The two transmission line modes are two different field distributions, that each propagate neatly without changing shape, and also without going from one mode to the other. For a symmetric win co-planar waveguide, the two transmission line modes each have a distinct symmetry: the "differential" mode, where the voltage on one conductor is always the opposite of the voltage of the other conductor, and the "common", where the voltage on both conductors is always the same. Each mode has its own characteristic impedance and propagation speed. The impedance and propagation speed are dependent on the geometry, e.g. line widths and gaps, of the transmission line. In the example of Fig. 16, the voltage of the qubit is coupled to the common mode: the voltage of the qubit causes a (roughly) equal voltage on both left and right conductor of the transmission line. On the other hand, the control current can be coupled to the differential mode by connecting it as shown and described herein. the benefit is obtained, when the common mode has a lower impedance (reduce Purcell loss) than the differential mode, but the differential mode has matched impedance to the control current source.

In accordance with at least some embodiments, the flux line described with Figs. 13 to 15 may be grounded in superconducting chips and superconducting chip packages in accordance to described with Figs. 2 to 11.

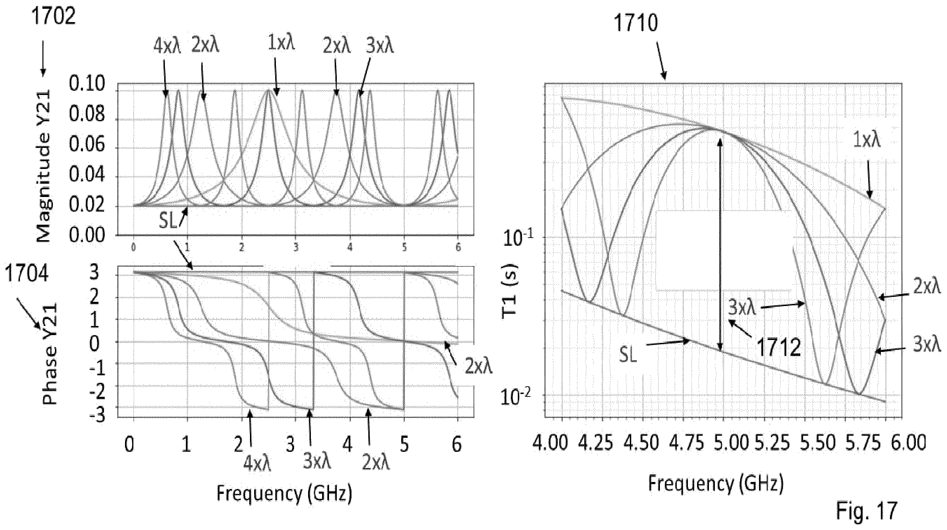

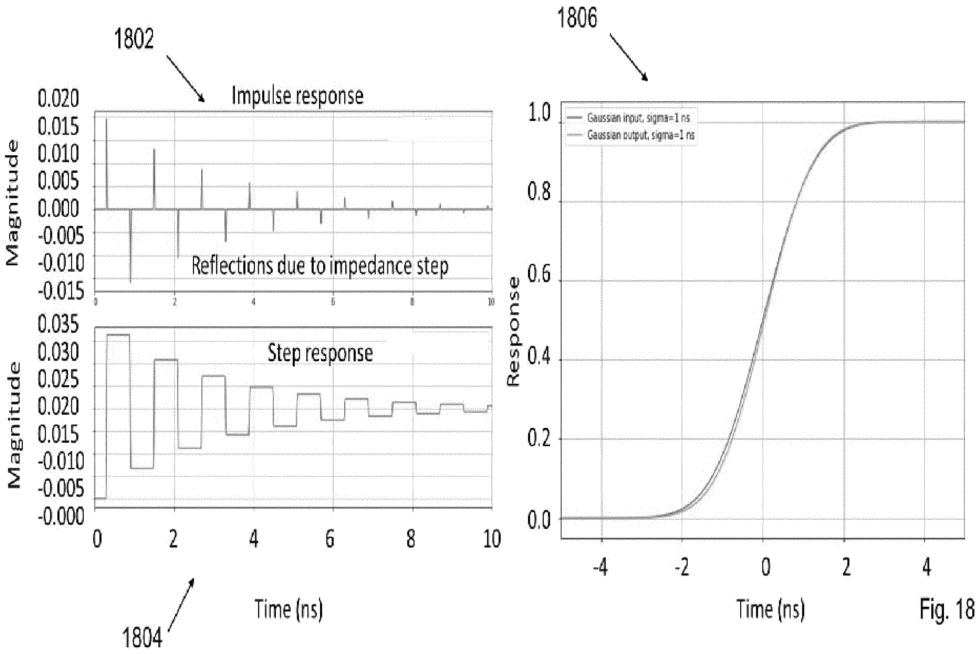

Fig. 17 and Fig. 18 illustrate examples of characteristics of flux lines in accordance with at least some embodiments. The flux lines may have an impedance mismatch between segments of the flux line. The impedance mismatched flux lines comprise first segments that each have an impedance of 50 Ohms and second segments that each have an impedance of 10 Ohms. Magnitude response 1702, phase response 1704 and the Purcell limit on T1 1710 are illustrated for the impedance mismatched flux lines that have second segments of different longitudinal dimensions, or lengths as well as for a standard 50 Ohm flux line, 'SL'. The 'SL' does not have an impedance mismatch and is matched with a system impedance, in this case 50 Ohms. The lengths of the second segments are multiples of a half a wavelength of a wave of a control signal carried by the flux line at a qubit frequency of the at least one qubit, thus

$$n \times \lambda_q/2, \quad (2)$$

where n is an integer value of 1, 2, 3, 4, 5, 6, 7, 8, 10 or higher, and $\lambda_q$ is wavelength of qubit frequency. The first segment may be connected to a source of a control signal which has an impedance of 50 Ohms. Accordingly, the first segment is matched to the impedance of the source. Response of a control signal fed to the flux line is illustrated by the magnitude response 1702 and the phase response 1704 over a frequency range from 0 to 6 GHz. At low frequencies, the magnitude responses of the impedance mismatched flux lines are substantially the same as for the standard 50 Ohm flux line, 'SL'. The phase responses of the flux lines are flat at low frequencies similar to the 'SL'. Purcell limit on T1 1710 for the flux lines show an improvement 1712 at a qubit frequency, i.e. 5 GHz, compared with the conventional flux line, 'SL'.

Fig. 18 illustrates an impulse response 1802 and a step response 1804 of the impedance mismatched flux line having the second segment length 3x $\lambda_q/2$. The impulse response 1802 and the step response 1804 show decaying reflections due to the impedance mismatch between segments of the flux line. Pulse shape 1806 of Gaussian pulse having 1ns rise time, sigma = 1ns, into the impedance mismatched flux line having the second segment length 3x $\lambda_q/2$ shows of a negligible change of pulse shape between an input pulse and an output.

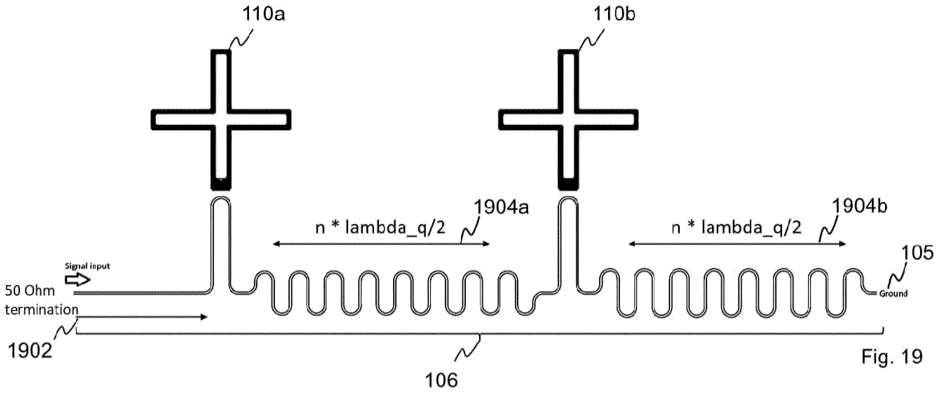

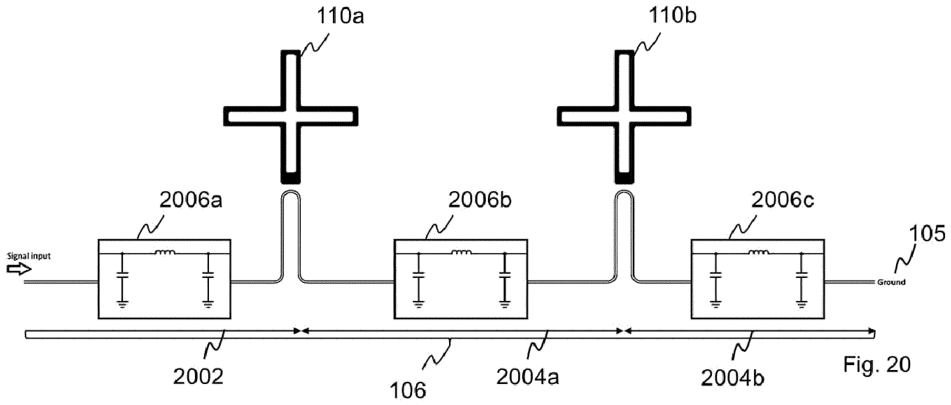

Figs. 19 and 20 illustrate examples of flux lines for multiplexed manipulation of qubits in accordance with at least some embodiments. The flux line 106 provides control of return current of the flux line, which reduces cross-talk between qubits that are coupled to the flux line, whereby multiplexed manipulation of the qubits is supported by the flux line in a manner which mitigates Purcell loss. The flux line 106 is illustrated on a superconducting chip, or chip package, comprising qubit islands 110a, 110b each of which comprises a qubit and a SQUID operatively connected to the qubit. The flux line comprises segments that are configured to control the return current of the flux line. The flux line comprises a first segment 1902, 2002 for connecting to an input terminal for receiving a control signal and one or more further segments 1904a, 1904b, 2004a, 2004b that are consecutive to the first segment 1902, 2002. The flux line extends between one end, where the flux line is connected to the input terminal and another end, where the flux line is routed to a termination to the ground 105. The flux line therefore extends longitudinally between its opposite ends. The qubits are arranged along the flux line in proximity of the flux line for coupling the control signal to the qubits. The qubits may be positioned to antinodes for current. The antinode for current is the antinode of the current of a control signal carried by the flux line. The first segment may be connected to the input terminal that has impedance of 50 Ohms at qubit frequencies of the qubits.

In example in accordance with at least some embodiments, the flux line 106 comprises a first segment 1902, 2002 for connecting to an input terminal for receiving a control signal and for coupling the control signal to a plurality of qubits arranged in proximity of the flux line. The flux line further comprises one or more further segments 1904a, 1904b, 2004a, 2004b consecutive to the first segment 1902, 2002. Each of the further segments is configured to extend between a first qubit of the plurality of qubits and, a second qubit of the plurality of qubits or a termination to the ground 105. The second qubit is a subsequent qubit after the first qubit along the flux line 106. The flux line comprises at least one of the following:

- a longitudinal dimension of the flux line between the first qubit, and the second qubit or the termination to the ground, of a given further segment of said one or more further segments 1904a, 1904b is a multiple of a half a wavelength of a wave of the control signal carried by the flux line at a qubit frequency of the first qubit of the given further segment; or
- the first segment and said one or more further segments 2004a, 2004b of the flux line 106 each comprise a low pass filter, or a band stop filter 2006a, 2006b, 2006c between the first qubit and, the second qubit or a termination to the ground.

In an example, qubits may be positioned along the flux line 106 at positions, where a distance of each qubit to, a next qubit controlled by the flux line or the termination to the to the ground 105, is a multiple of a half a wavelength of the qubit frequency. Thus, the distance of each qubit to, a next qubit controlled by the flux line or the termination to the to the ground 105, may be in accordance with Formula (2).

In example in accordance with at least some embodiments, a longitudinal dimension of the flux line 106 between a qubit of the plurality of qubits that is the closest to the termination to the ground is a multiple of a half a wavelength of a wave of the control signal carried by the flux line at a qubit frequency of the qubit of the plurality of qubits that is the closest to the termination to the ground.

In example in accordance with at least some embodiments, the first segment 1902 comprises an impedance mismatch at the qubit frequency of at least one qubit. The impedance mismatch may be provided as described with Fig. 13 for mitigating Purcell loss at qubit frequencies.

In example in accordance with at least some embodiments, the first segment 1902 comprises a first section and a second section that are consecutive sections of the flux line and wherein the second section is closer to a qubit from the input terminal than the first section and wherein the second section has a lower impedance than the first section. The lower impedance may be provided as described with Fig. 13 for mitigating Purcell loss at qubit frequencies.

In example in accordance with at least some embodiments, the first segment 2002 comprises a first section and a second section that are consecutive sections of the flux line and wherein the second section is closer to a qubit from the input terminal than the first section and wherein the second section and the first section are connected by a low pass filter, or a band stop filter, 2006a configured to connect the first section with the second section. The filter may be provided for mitigating Purcell loss at qubit frequencies as described with Fig. 15.

In example in accordance with at least some embodiments, the first segment comprises a first section and a second section that are consecutive sections of the flux line and wherein the second section is closer to a qubit from the input terminal than the first section and wherein the second section and the first section are connected by an inductor connected in series with the first section and the second section. The inductor may be provided as described with Fig. 14 for mitigating Purcell loss at qubit frequencies.

In example in accordance with at least some embodiments, there is provided a superconducting chip, or chip package, for supporting multiplexed manipulation of qubits by a flux line. The superconducting chip, or chip package, comprises a plurality of qubits on one or more substrates, and one or more flux lines in accordance with at least some embodiments for manipulating said plurality of qubits.

In example in accordance with at least some embodiments, the superconducting chip, or chip package, may be in accordance to described with Figs. 3 to 11.

In example in accordance with at least some embodiments, the superconducting chip, or chip package, comprises:

- at least one termination to the ground 105 on an opposite side of a first substrate 104, 406 with respect to said plurality of qubits or on a second substrate 406 stacked with the first substrate 104; and
- a conductor arrangement 108 connected to at least flux line of the one or more flux lines at an antinode for current in proximity of at least one qubit of the plurality of qubits and arranged to route the at least one flux line to the at least one termination to the ground 105.

In example in accordance with at least some embodiments, the superconducting chip, or chip package, wherein the conductor arrangement 108 is configured to:

- extend through the first substrate 104; and
- connect the at least one flux line 106 to the at least one termination to the ground 105 on the opposite side of the first substrate with respect to the plurality of qubits.

In example in accordance with at least some embodiments, the superconducting chip, or chip package, wherein the conductor arrangement 108 is configured to:

- extend through the second substrate 406; and
- connect the at least one flux line 106 to the at least one termination to the ground 105 on the opposite side of the second substrate with respect to a side of the second substrate facing the plurality of qubits.

In example in accordance with at least some embodiments, the superconducting chip, or chip package, wherein the conductor arrangement 108 is configured to:

- extend between the first substrate 104 and the second substrate 406; and
- connect the at least one flux line to the at least one termination to the ground 105 on the second substrate 406.

In example in accordance with at least some embodiments, the superconducting chip, or chip package, wherein the conductor arrangement is configured to connect the at least one flux line to at least one termination to the ground 105 through at least one of the following: at least one through-silicon via (TSV); or at least one bonding element (808); or a series of at least one through-silicon via (TSV) and at least one conductor line; or a series of at least one bonding element 808, at least one through-silicon via (TSV) and at least one conductor line.

In example in accordance with at least some embodiments, the superconducting chip, or chip package, wherein a longitudinal dimension of the conductor arrangement is a multiple of a half a wavelength of a wave of the control signal carried by the flux line at a qubit frequency of a qubit that is closest to the termination to the ground along the flux line.

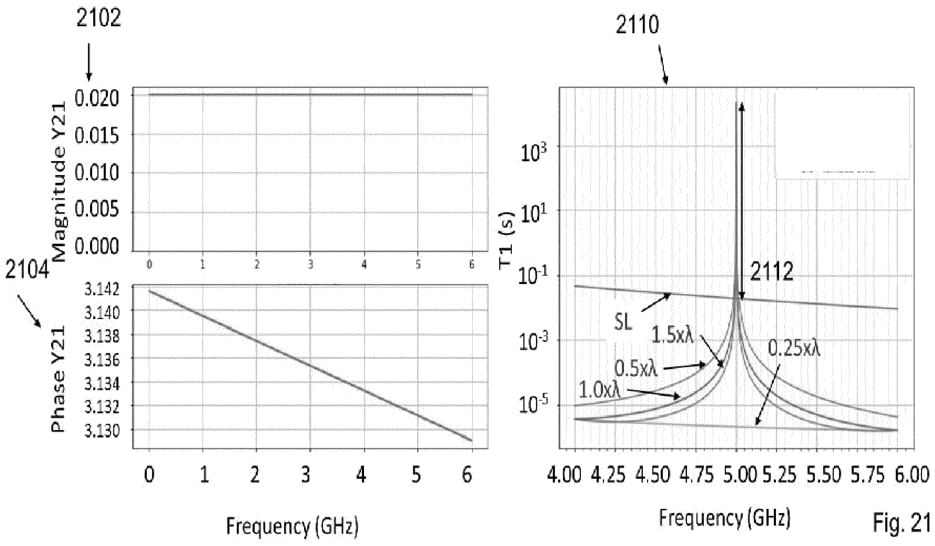

Fig. 21 illustrates examples of characteristics of flux lines for multiplexed manipulation of qubits in accordance with at least some embodiments. The flux lines comprise a flux line configured to support multiplexed manipulation of qubits in accordance to described with Fig. 19 and a standard 50 Ohm flux line, 'SL'. The flux line configured to support multiplexed manipulation of qubits in accordance to described with Fig. 19 comprises one end that is connected to the source for control signal and another end that is connected to a termination to the ground. Length, or i.e. a longitudinal dimension, of the flux line from the termination to the ground to the qubit is a multiple of a half a wavelength of a wave of the control signal carried by the flux line at a qubit frequency the qubit in accordance with Formula (2). Impedance of the 'SL' and an impedance of a source of control signal are both 50 Ohms. Response of a control signal fed to the flux line is illustrated by the magnitude response 2102 and the phase response 2104 over a frequency range from 0 to 6 GHz. The magnitude response and phase response of the flux line shows that the flux line configured to support multiplexed manipulation of qubits in accordance to described with Fig. 19 does not have substantial effect on the magnitude response and phase response. Purcell limit on T1 2110 for the flux lines show an improvement 2112 at a qubit frequency, i.e. 5 GHz, compared with the conventional flux line, 'SL'. The comparison is illustrated for lengths the following multiples of wavelength at the qubit frequency: 0.25, 0.5,1.0, 1.5. The improvement 2112 of the Purcell limit can be observed at multiples of a half of the wavelength at qubit frequency.

Electromagnetic couplings between components of superconducting circuit(s), may be, for example, capacitive, inductive, or both capacitive and inductive. In some embodiments, couplings between components are couplings through a space between two chips on which two components are respectively positioned. For example, in some implementations, a qubit positioned on a first substrate may be electromagnetically coupled to a readout resonator or a flux line positioned on a second substrate that may be bump bonded to and facing the first substrate. In some embodiments, couplings are in-plane, with a direction of a coupling electric field and/or magnetic field being substantially in a plane of a side of a chip on which both of two components are positioned. For example, in some implementations, a qubit on a first surface of a silicon substrate may be electromagnetically coupled to a readout resonator or a flux line on the first surface of the silicon substrate.

Superconducting quantum circuits comprise components for performing computational operations based on quantum operations. Components of the superconducting quantum circuits, also referred to quantum circuit components, or quantum computing circuit components, disclosed herein include circuit components for performing the quantum operations. That is, the superconducting quantum circuit components are configured to make use of quantum-mechanical phenomena, such as superposition and entanglement, to perform operations on data in a non-deterministic manner. Certain superconducting quantum circuit components, such as qubits, may be configured to represent and operate on information in more than one state simultaneously. Examples of superconducting quantum circuit components include circuit elements such as quantum LC oscillators, qubits (e.g., flux qubits, phase qubits, or charge qubits), readout resonators, flux lines, readout transmission lines, co-planar waveguides, amplifiers, and superconducting quantum interference devices (SQUIDs) (e.g., RF-SQUID or DC SQUID), among others.

In contrast, classical circuit elements generally process data in a deterministic manner. Classical circuit elements may be configured to collectively carry out instructions of a computer program by performing basic arithmetical, logical, and/or input/output operations on data, in which the data is represented in analog or digital form. In some implementations, classical circuit elements may be used to transmit data to and/or receive data from the quantum circuit components through electrical or electromagnetic connections. Examples of classical circuit elements include circuit elements based on CMOS circuitry, rapid single flux quantum (RSFQ) devices, reciprocal quantum logic (RQL) devices and ERSFQ devices, which are an energy-efficient version of RSFQ that does not use bias resistors.

Any or all of the components mentioned in this disclosure, including the qubits, the readout resonators, the flux lines, the readout transmission lines, and the amplifiers, may be made of a superconductor material, such as aluminum, niobium, or titanium nitride, among other superconductor materials. The components may include both superconductor and non-superconductor material.

Fabrication of the electrical components disclosed herein may entail the deposition of one or more materials, such as superconductors, dielectrics and/or metals. Depending on the selected material, these materials can be deposited using deposition processes such as chemical vapor deposition, physical vapor deposition (e.g., evaporation or sputtering), or epitaxial techniques, among other deposition processes. Processes for fabricating electrical components described herein may entail the removal of one or more materials from a device during fabrication. Depending on the material to be removed, the removal process may include, e.g., wet etching techniques, dry etching techniques, or lift-off processes. The materials forming the electrical components described herein can be patterned using known lithographic techniques (e.g., photolithography or e-beam lithography). It should be noted that the processes for fabricating the electrical components described herein may further entail flip-chip manufacturing, where a device is flipped upside down and directly attached to another device, allowing for more efficient and compact packaging.

During operation of a quantum computational system that uses circuit elements formed, in part, from superconductors, such as the circuit elements described herein, the circuit elements are cooled down within a cryostat to temperatures that allow a superconductor material to exhibit superconducting properties. A superconductor (also referred to as superconducting) material may be understood as material that exhibits superconducting properties at or below a superconducting critical temperature. Examples of superconducting material include aluminum (superconductive critical temperature of 1.2 kelvin) and niobium (superconducting critical temperature of 9.3 kelvin). Accordingly, superconducting structures, such as superconducting traces and superconducting ground planes, are formed from material that exhibits superconducting properties at or below a superconducting critical temperature.

In certain implementations, control signals for the quantum circuit components (e.g., qubits and qubit couplers) may be provided using classical circuit elements that are electrically and/or electromagnetically coupled to the quantum circuit components. The control signals may be provided in digital and/or analog form.

While this specification contains many specific implementation details, these should not be construed as limitations on the scope of what may be claimed, but rather as descriptions of features that may be specific to particular implementations. Certain features that are described in this specification in the context of separate implementations may also be implemented in combination in a single implementation. Conversely, various features that are described in the context of a single implementation may also be implemented in multiple implementations separately or in any suitable sub-combination.

Although the exemplary embodiments of the invention are described herein, it should be noted that various changes and modifications could be made in the embodiments of the invention, without departing from the scope of legal protection which is defined by the appended claims. In the appended claims, the word "comprising" does not exclude other elements or operations, and the indefinite article "a" or "an" does not exclude a plurality. The mere fact that certain measures are recited in mutually different dependent claims does not indicate that a combination of these measures cannot be used to advantage.

Moreover, although features may be described above as acting in certain combinations and even initially claimed as such, one or more features from a claimed combination may in some cases be excised from the combination, and the claimed combination may be directed to a sub-combination or variation of a sub-combination.

Particular embodiments of the subject matter have been described. Other embodiments are within the scope of the following claims. For example, the actions recited in the claims may be performed in a different order and still achieve desirable results. As one example, the processes depicted in the accompanying figures do not necessarily require the particular order shown, or sequential order, to achieve desirable results.

LIST OF REFERENCE SIGNS

| | |
|---|---|
| 100, 101 | superconducting chip |
| 102 | qubit |
| 103 | input terminal for control signal |
| 104 | substrate |
| 105 | termination to the ground |
| 106 | flux line |
| 107 | SQUID |
| 108 | conductor arrangement |
| 109 | the ground |
| 110, 110a, 110b | qubit island |
| | |
| 111 | position for coupling the control signal to the at least one qubit |
| 208, 210 | portions of conductor arrangement |
| 400, 401, 600, 601, 800, 801, 1000, 1001 | superconducting chip packages |
| 402, 602, 802 | gap between substrates |
| 406 | substrate |
| 410 | bonding elements |
| 808 | bonding element |
| 910 | conductor line |
| 1200 | apparatus |
| 1202 | superconducting chip or superconducting chip package |
| 1204 | control unit |
| 1206 | memory |
| 1208 | executable instructions |
| 1301 | control signal |
| 1302 | first segment of the flux line |
| 1304 | second segment of the flux line |
| 1306 | Impedance mismatch |
| 1404 | second segment of the flux line |

(continued)

| 1406 | inductor |
|---|---|
| 1504 | second segment of the flux line |
| 1506 | filter |
| 1601 | position coupling the control signal to the at least one qubit |
| 1604 | second segment |
| 1606 | first section of second segment |
| 1608 | second section of second segment |
| 1610 | filter |
| 1702 | Magnitude response |
| 1704 | phase response |
| 1710 | Purcell limit on T1 |
| 1712 | improvement of Purcell limit on T1 |
| SL | standard 50 Ohm flux line |
| 1802 | impulse response |
| 1804 | step response |
| 1806 | pulse shape |
| 1902, 2002 | first segment of the flux line |
| 1904a, 1904b, 2004a, 2004b | further segments of the flux line |
| 2006a, 2006b, 2006c | low pass filter, or a band stop filter |
| 2102 | magnitude response |
| 2104 | phase response |
| 2110 | Purcell limit on T1 |
| 2112 | improvement of Purcell limit on T1 |

**Claims**

1. A flux line (106) for manipulating a plurality of qubits, comprising:

   - a first segment (1902) for connecting to an input terminal for receiving a control signal and for coupling the control signal to a plurality of qubits arranged in proximity of the flux line; and
   - one or more further segments (1904a, 1904b) consecutive to the first segment (1902), wherein each of the further segments is configured to extend between a first qubit of the plurality of qubits and, a second qubit of the plurality of qubits or a termination to the ground, wherein the second qubit is a subsequent qubit after the first qubit along the flux line (106); and the flux line comprises at least one of the following:

      ▪ a longitudinal dimension of the flux line between the first qubit and, the second qubit or the termination to the ground, of a given further segment of said one or more further segments (1904a, 1904b) is a multiple of a half a wavelength of a wave of the control signal carried by the flux line at a qubit frequency of the first qubit of the given further segment; or
      ▪ the first segment and said one or more further segments (2004a, 2004b) of the flux line (106) each comprise a low pass filter or a band stop filter (2006a, 2006b, 2006c) between the first qubit and, the second qubit or a termination to the ground.

2. The flux line of claim 1, wherein a longitudinal dimension of the flux line between a qubit of the plurality of qubits that is the closest to a termination to the ground, and the termination to the ground, is a multiple of a half a wavelength of a wave of the control signal carried by the flux line at a qubit frequency of the qubit of the plurality of qubits that is the closest to the termination to the ground.

3. The flux line of claim 1 or 2, wherein the first segment comprises an impedance mismatch at the qubit frequency of at least one qubit.

4. The flux line of claim 1, 2 or 3, wherein the first segment comprises a first section and a second section that are consecutive sections of the flux line and wherein the second section is closer to a qubit from the input terminal than the first section and wherein the second section has a lower impedance than the first section.

5. The flux line of claim 1, 2 or 3, wherein the first segment comprises a first section and a second section that are consecutive sections of the flux line and wherein the second section is closer to a qubit from the input terminal than the first section and wherein the second section and the first section are connected by a low pass filter or a band stop filter, configured to connect the first section with the second section.

6. The flux line of claim 1, 2 or 3, wherein the first segment comprises a first section and a second section that are consecutive sections of the flux line and wherein the second section is closer to a qubit from the input terminal than the first section and wherein the second section and the first section are connected by an inductor connected in series with the first section and the second section.

7. A superconducting chip, or chip package, comprising:

   - a plurality of qubits on one or more substrates; and

   one or more flux lines according to any of the claims 1 to 6 for manipulating said plurality of qubits.

8. The superconducting chip, or chip package, according to claim 7, comprising:

   - at least one termination to the ground (105) on an opposite side of a first substrate (104, 406) with respect to said plurality of qubits or on a second substrate (406) stacked with the first substrate (104); and
   - a conductor arrangement (108) connected to at least flux line of the one or more flux lines at an antinode for current in proximity of at least one qubit of the plurality of qubits and arranged to route the at least one flux line to the at least one termination to the ground (105).

9. The superconducting chip, or chip package, according to claim 8, wherein the conductor arrangement (108) is configured to:

   - extend through the first substrate (104); and
   - connect the at least one flux line (106) to the at least one termination to the ground (105) on the opposite side of the first substrate with respect to the plurality of qubits.

10. The superconducting chip, or chip package, according to claim 8, wherein the conductor arrangement (108) is configured to:

    - extend through the second substrate (406); and
    - connect the at least one flux line (106) to the at least one termination to the ground (105) on the opposite side of the second substrate with respect to a side of the second substrate facing the plurality of qubits.

11. The superconducting chip, or chip package, according to claim 8, wherein the conductor arrangement (108) is configured to:

    - extend between the first substrate (104) and the second substrate (406); and
    - connect the at least one flux line to the at least one termination to the ground (105) on the second substrate (406).

12. The superconducting chip, or chip package, of any of the claims 8 to 11, wherein the conductor arrangement is configured to connect the at least one flux line to at least one termination to the ground (105) through at least one of the following: at least one through-silicon via (TSV); or at least one bonding element (808); or a series of at least one through-silicon via (TSV) and at least one conductor line; or a series of at least one bonding element (808), at least one through-silicon via (TSV) and at least one conductor line.

13. The superconducting chip, or chip package, of any of the claims 8 to 12, wherein a longitudinal dimension of the conductor arrangement is a multiple of a half a wavelength of a wave of the control signal carried by the flux line at a qubit frequency of a qubit that is closest to the termination to the ground along the flux line.

14. A quantum computing apparatus comprising at least one superconducting chip, or chip package, according to any of claims 8 to 13 and a control unit connected to the at least one superconducting chip, or chip package, and the control unit is configured to feed one or more control signals to the one or more flux lines for manipulating said plurality of qubits.

Fig. 1a

Fig. 1b

Fig. 2

Fig. 3

Fig. 4

Fig. 5

Fig. 6

Fig. 7

Fig. 8

Fig. 9

1000

106    808    102    104    802

208    406

105

Fig. 10

1001

106    808    102    104    802

210    208    406

910

Fig. 11

Fig. 12

Fig. 13

Fig. 14

Fig. 15

Fig. 16

Fig. 17

Fig. 18

Fig. 19

Fig. 20

Fig. 21

Europäisches
Patentamt

European
Patent Office

Office européen
des brevets

## EUROPEAN SEARCH REPORT

**Application Number**

EP 25 16 3161

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/021372 A1 (NAKAMURA YASUNOBU [JP] ET AL) 20 January 2022 (2022-01-20) * abstract * * paragraph [0002] - paragraph [0003] * * paragraph [0005] - paragraph [0011] * * paragraph [0028] - paragraph [0147]; figures 1-15 * | 1-14 | INV. G06N10/40 H10N69/00 |
| X | KANNAN BHARATH ET AL: "Waveguide Quantum Electrodynamics with Superconducting Qubits", MASSACHUSETTS INSTITUTE OF TECHNOLOGY, [Online] 31 August 2018 (2018-08-31), pages 1-87, XP055840713, Retrieved from the Internet: URL:http://hdl.handle.net/1721.1/120400> [retrieved on 2021-09-14] * abstract * * chapters 3-4; page 39 - page 78; figures 3-1 - 4-17 * | 1-14 | |
| A | BRONN NICHOLAS T ET AL: "Broadband filters for abatement of spontaneous emission in circuit quantum electrodynamics", APPLIED PHYSICS LETTERS, AMERICAN INSTITUTE OF PHYSICS, 2 HUNTINGTON QUADRANGLE, MELVILLE, NY 11747, vol. 107, no. 17, 26 October 2015 (2015-10-26), XP012201664, ISSN: 0003-6951, DOI: 10.1063/1.4934867 [retrieved on 1901-01-01] * the whole document * | 3 | TECHNICAL FIELDS SEARCHED (IPC) G06N H02N H10N |

-/--

The present search report has been drawn up for all claims

| Place of search | Date of completion of the search | Examiner |
|---|---|---|
| The Hague | 30 June 2025 | Hasnas, Sergiu |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 25 16 3161

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/044044 A1 (LAMPERT LESTER [US] ET AL) 7 February 2019 (2019-02-07)<br>* abstract *<br>* paragraph [0001] - paragraph [0004] *<br>* paragraph [0025] - paragraph [0133]; figures 1A-14 * | 8-12 | |
| | ----- | | |
| | | | **TECHNICAL FIELDS SEARCHED (IPC)** |

The present search report has been drawn up for all claims

| Place of search | Date of completion of the search | Examiner |
|---|---|---|
| The Hague | 30 June 2025 | Hasnas, Sergiu |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
.............................................................................
& : member of the same patent family, corresponding
   document

EPO FORM 1503 03.82 (P04C01)

page 2 of 2

## ANNEX TO THE EUROPEAN SEARCH REPORT
## ON EUROPEAN PATENT APPLICATION NO.

EP 25 16 3161

This annex lists the patent family members relating to the patent documents cited in the above-mentioned European search report.
The members are as contained in the European Patent Office EDP file on
The European Patent Office is in no way liable for these particulars which are merely given for the purpose of information.

30-06-2025

| Patent document cited in search report | Publication date | Patent family member(s) | | Publication date |
|---|---|---|---|---|
| US 2022021372 A1 | 20-01-2022 | CN | 113169437 A | 23-07-2021 |
| | | JP | 7369459 B2 | 26-10-2023 |
| | | JP | WO2020105732 A1 | 14-10-2021 |
| | | TW | 202029564 A | 01-08-2020 |
| | | US | 2022021372 A1 | 20-01-2022 |
| | | WO | 2020105732 A1 | 28-05-2020 |
| US 2019044044 A1 | 07-02-2019 | NONE | | |

EPO FORM P0459

For more details about this annex : see Official Journal of the European Patent Office, No. 12/82